# EUROPEAN PATENT SPECIFICATION

(11) **EP 3 392 664 B1**
(45) Date of publication and mention of the grant of the patent: **12.02.2020**
(21) Application number: 18166065.5
(22) Date of filing: 06.04.2018
(51) Int. Cl.: G01R 15/12, G01R 1/20, G01R 1/067

(54) **ELECTRIC QUANTITY MEASURING DEVICE**
MESSGERÄT FÜR ELEKTRISCHE GRÖSSE
DISPOSITIF DE MESURE D'UNE QUANTITÉ ÉLECTRIQUE

(30) Priority: 19.04.2017 IT 201700043042
(43) Date of publication of application: 24.10.2018
(73) Proprietor: D.E.M. S.p.A., 32013 Longarone, (BL) (IT)
(72) Inventor: Berton, Mattia, 32013 Longarone BL (IT)
(74) Representative: Perani & Partners S.p.A.

(56) References cited:
- CN-A- 101 769 957
- CN-B- 101 846 698
- US-A1- 2014 009 189

## Description

### FIELD OF THE INVENTION

The present disclosure relates to a device for measuring electric quantities, particularly the AC Current and the AC voltage at its terminals, as defied in the preamble of claim 1.

Furthermore, the present disclosure relates to a network analyzing device which is configured to measure, at its input clamps, both the AC current and the AC voltage.

### Discussion of the related art

In the prior art, devices are used that can measure electric quantities detected by special electric quantity transducers. An electric quantity transducer is, for example, a current sensor configured to detect the alternating current that flows in an electric conductor. A transducer is configured to detect a specific electric quantity to generate, at its output, a current or voltage signal that may be processed to measure the intensity of the detected electric quantity.

This current or voltage signal is provided to a device for detecting electric quantities, such as a network analyzer. A known network analyzer is configured to receive either an AC voltage or an AC current according to the hardware configuration of the network analyzer.

A network analyzer configured to detect an AC voltage at its input clamps, must be connected to a current sensor that would provide an AC voltage at its output.

Likewise, a network analyzer configured to detect an AC current at its input clamps, must be connected to a current sensor that would generate an AC current at its output.

Network analyzers usually comprise a processing circuit having an ADC converter which converts the input signal from AC to DC to generate an output signal to be provided to a microcontroller. The microcontroller processes the signal to take measurements on the detected electric quantities.

In other words, the input clamps have a specific circuit that only allows measurements to be taken if the proper AC voltage or current parameter is provided at the input. The input circuit is designed to receive either AC current only or AC voltage only, to provide an AC voltage to the ADC converter. Therefore, a network analyzer configured to receive AC voltage at its input cannot take measurements if its input receives AC current, and vice versa.

The measurement signal processed by the microcontroller may be of analog or digital type. This measurement signal may be sent via a special communication port to an outer processing unit, such as a PLC or a PC, which can acquire and possibly further process the measurement signal using specific coefficients of proportionality to provide a measurement of the electric current that flows in the cable.

Prior art electric quantity measuring devices are disclosed in CN 101769957, 101846698 CN B and US 2014/009189 A1.

### Prior art problem

The problem of prior art network analyzers consists in that only one type of measurement can be taken on the same pair of input clamps. This means that a measurement can be only taken if the input signal is provided as the correct quantity between AC current or AC voltage.

In order to obviate this drawback, there will be twice as many pairs of clamps, and respective processing circuits adapted to measure both AC current and AC voltage on pairs of different clamps.

Nevertheless, this solution leads to an increase of the dimensions of the measuring device and, accordingly, to an increase of production costs and power consumption associated with the same measuring device.

### SUMMARY OF THE INVENTION

The object of the present invention is to provide an electric quantity measuring device that can obviate the drawbacks of the prior art.

A further object of the present invention is to provide an electric quantity measuring device that has smaller dimensions and low consumption and costs.

Yet another object of the present invention is to provide a network analyzing device that is configured to take both AC current and AC voltage measurements at its input.

These objects are fulfilled by an electric quantity measuring device as defined in claim 1 hereinbelow.

### Advantages of the Invention

One embodiment can provide an electric quantity measuring device that is able receive both an AC current signal and an AC voltage signal at its input on the same pair of clamps.

One embodiment can provide an electric quantity measuring device that has a small size.

One embodiment can provide an electric quantity measuring device that can have reduced production costs.

One embodiment can provide an electric quantity measuring device that can have reduced power consumption.

One embodiment can provide a network analyzer device that can take AC current measurements by receiving either an AC current signal or an AC voltage signal at its input on the same pair of clamps.

### BRIEF DESCRIPTION OF THE DRA WINGS

The characteristics and advantages of the present disclosure will appear from the following detailed description of a possible practical embodiment, illustrated as a nonlimiting example in the set of drawings, in which:
- Figure 1 shows a block diagram of an electric quantity measuring device of the present invention in a first operating configuration,
- Figure 2 shows the block diagram of the device of Figure 1 in a second operating configuration,
- Figure 3 shows a further embodiment of an electric quantity measuring device of the present invention,
- Figure 4 shows the electric quantity measuring device of Figures 1 to 3 in greater detail.

### DETAILED DESCRIPTION

Even when this is not expressly stated, the individual features as described with reference to the particular embodiments shall be intended as auxiliary to and/or interchangeable with other features described with reference to other exemplary embodiments.

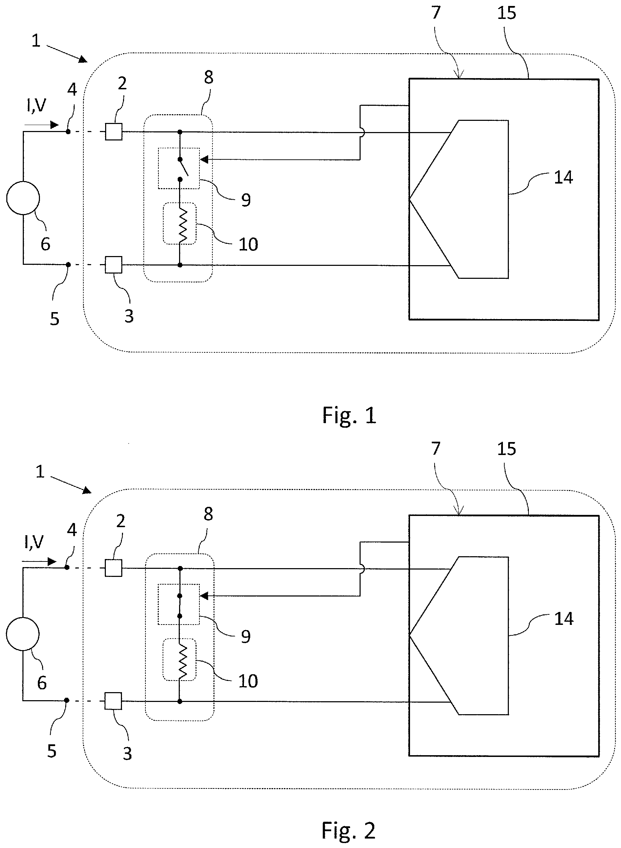

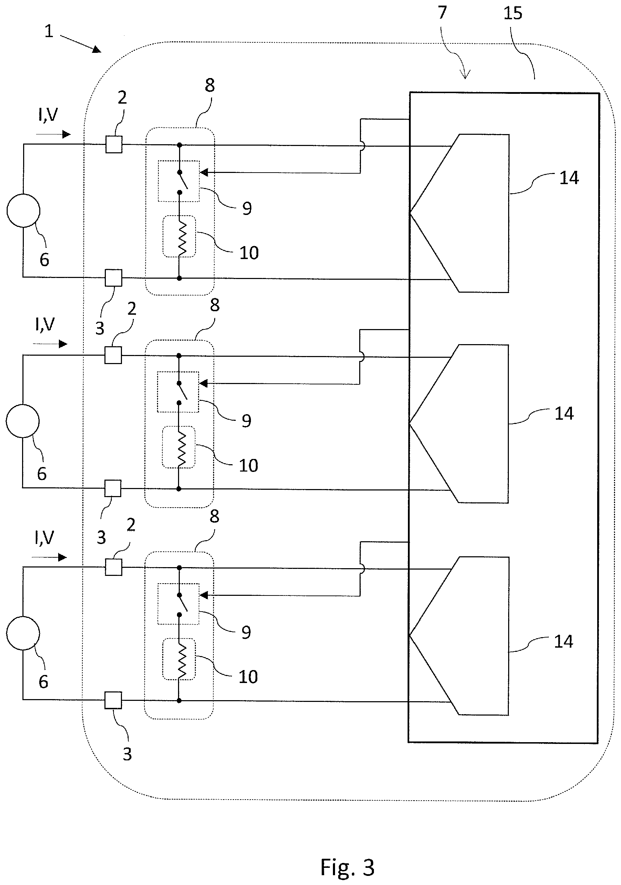

The present invention relates to an electric quantity measuring device that is generally designated by numeral 1 in Figures 1 to 4. Particularly, Figure 3 shows a preferred embodiment, in which the electric quantity measuring device 1 is a three-phase network analyzer, or energy meter.

The electric quantity measuring device 1 comprises two input clamps 2, 3, which are adapted to be electrically connected with two respective output clamps 4, 5 of an electric quantity transducer.

The two input clamps 2, 3 are configured to receive an AC current I or an AC voltage V at their input.

The electric quantity transducer 6 is a device configured to detect an electric quantity and generate an output current or voltage signal whose intensity is a function of the intensity of the physical quantity that has been detected.

For example, the electric quantity transducer 6 may be a current sensor configured to sense the intensity of the alternating current that flows in a conductor, to thereby generate an output AC current I or AC voltage signal V whose intensity is proportional to electric current value that has been detected by the sensor.

In other words, the AC current I and the AC voltage V are the two signals that may be alternately found at the input of the clamps 2, 3 of the electric quantity measuring device 1.

In one aspect, these two signals may be used to take measurements and make calculations as is usual in an electric quantity measuring device 1, such as a network analyzer that is configured to calculate electric quantities including active power, apparent power, reactive power, frequency, and energy.

The electric quantity measuring device 1 comprises a processing unit 7, which is electrically connected with the two input clamps 2, 3, and is configured to generate at least one electric quantity measuring signal related to the AC current I or the AC voltage V at the input of the two input terminals 2, 3.

The electric quantity measuring device 1 also comprises a switch device 8 whose ends are electrically connected with the two input clamps 2, 3.

The switch device 8 comprises an electronic switch 9 and resistive means 10 connected in series. One end of the electronic switch 9 is electrically connected with one of the two input clamps 2, 3, whereas one end of the resistive means 10 is electrically connected with the other of the two input clamps 2, 3.

The electronic switch 9 is operatively configured to switch between an open configuration in which it prevents the passage of electric current between the two input clamps 2, 3 and a closed configuration in which it allows the passage of electric current between the two input clamps 2, 3.

Preferably, the resistive means 10 comprise a single resistive element or a plurality of electrically connected resistive elements, for example connected in series.

Preferably, the switch device 8 is configured to have at least 6 ampere of alternating current flow through the series of the electronic switch 9 and the resistive means 10, when the electronic switch 9 is in the closed configuration.

The processing unit 7 is electrically connected with the two clamps 2, 3 and, as a result, with the ends of the switch device 8.

In one aspect, the processing unit 7 is connected to the ground via a ground terminal GND and to a power supply voltage via the terminal Vdc.

Advantageously, the processing unit 7 is configured to detect a potential difference value at the two input clamps 2, 3 and, according to the detected potential difference value, the processing unit 7 is configured to cause the electronic switch 9 to switch to the open configuration when it detects that the two clamps 2, 3 receive the AC voltage at their inputs, and to cause the electronic switch 9 to switch to the closed configuration when it detects that the two clamps 2, 3 receive the AC current I at their inputs.

Namely, the processing unit 7 is configured to recognize, according to the potential difference value detected at the two clamps 2, 3, if an AC voltage signal V or an AC current signal I is being provided at its input by the electric quantity transducer 8. Once the type of input signal has been detected, the processing unit causes the electronic switch 9 to switch between the open and closed configurations.

In other words, if an electric quantity transducer 6 that generates an output AC voltage signal V is connected to the two clamps 2, 3, the processing unit 7 will cause the electronic switch 9 to switch to the open configuration. Thus, in the open configuration of the electronic switch 9, the potential difference value at the two clamps 2, 3 is substantially the same as the AC voltage value V.

On the other hand, if an electric quantity transducer 6 that generates an output AC current signal I is connected to the two clamps 2, 3, the processing unit 7 will cause the electronic switch 9 to switch to the closed configuration. In the closed configuration of the electronic switch 9, the AC current I flows between the two clamps 2, 3, also through the resistive means 10. Therefore, in the closed configuration, the AC current I flows through the resistive means and generates a potential difference value at the two clamps 2, 3 that is a function of the intensity of the AC current I and of the impedance value of the resistive means 10.

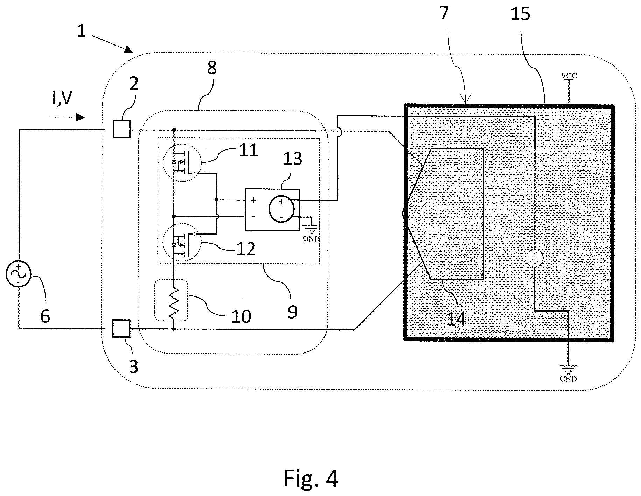

The electronic switch 9 comprises two antiserially-connected N-type Mosfet transistors 11, 12 which are powered with a floating voltage (Figure 4).

The processing unit 7 is configured to control the floating voltage between the gate and the source of the two Mosfet transistors 11, 12, thereby causing the electronic switch 9 to switch between the open configuration and the closed configuration. With this configuration, the alternating current I at 50/60 Hz can be blocked if the potential difference between the gate and the source is zero (i.e., Vgs=0). It shall be noted that the N-type Mosfet transistors 11, 12 have a very low resistance (i.e. Rds_on).

As used herein, the term N-type Mosfet transistor is intended to designate a N-MOS transistor of known type in which current enters the drain and exits from the source. In addition, as used herein, an antiserial connection is intended to indicate, like in the prior art, a serial connection (i.e. the connection mode in which one connection point is only provided between two parts), in which the polarities of the terminals are coupled by equal signs.

The electronic switch 9 comprises a charge pump 13 in signal communication with the processing unit 7 to set the voltage between the gate and source electrodes Vgs of the two antiserially-connected Mosfet transistors 11, 12 to at least 5V.

The processing unit 7 is configured to generate a PWM (Pulse Width Modulation) control signal with a preset duty cycle frequency.

In one aspect, the processing unit 7 comprises an ADC converter 14, connected with the two input clamps 2, 3, and hence also with the ends of the switch device 8.

Thus, the potential difference value at the two input clamps 2, 3 is received by the ADC converter 14, which generates an output signal according to such voltage value.

Furthermore, the processing unit 7 also comprises a microcontroller 15 in signal communication with the ADC converter 14 and configured to process the output signal to thereby generate at least one electric quantity measuring signal.

Preferably, the microcontroller 15 is in signal communication with the electronic switch 9, and is configured to control the electronic switch 9 to cause it to switch to the open configuration when the two clamps 2, 3 receive the AC voltage V at their inputs or to cause it to switch to the closed configuration when the two clamps 2, 3 receive the AC current I at their inputs.

It should be noted that the detection of the potential difference value at the two input clamps 2, 3, which later allows the microcontroller 15 to control the operation of the electronic switch 9, is carried out by the ADC converter 14. Thus, the ADC converter 14 reads the potential difference value at the two input clamps 2, 3 and generates an output signal according to the detected value. This signal is processed by the microcontroller 15 which both generates an electric quantity measuring signal and recognizes the type of the input signal at the two clamps 2, 3.

Thus, the microcontroller 15 can detect whether there is an AC voltage V or an AC current I at the input of the two clamps.

According to a preferred arrangement of the invention, the microcontroller 15 is configured to generate the PWM control signal at a preset frequency of about 100 kHz, to control the charge pump 13. Accordingly, the charge pump 13 generates the fluctuating voltage, and sets the voltage between the gate and the source (i.e. Vgs) of the two Mosfet transistors 11,12 to a value of at least 5 V, which is required to maintain the Rds_on of the Mosfet transistors 11, 12 low enough to avoid overheating of the same Mosfet transistors 11, 12 with 6 ampere of alternating current I flowing therethrough.

The microcontroller 1 is configured to switch the electronic switch 9 to the open configuration when the potential difference value between one of the two clamps 2, 3 and the ground GND of the processing unit 7 has a negative sign.

According to a further preferred embodiment as shown in Figure 3, the electric quantity measuring device 1 is a three-phase network analyzer, and comprises three pairs of input clamps 2, 3, wherein each pair of terminals 2, 3 are adapted to be electrically connected with two respective output terminals 4, 5 of an electric quantity transducer 6 to receive an AC current I or an AC voltage at its input. The electric quantity device 1 comprises three respective switch devices 8, each electrically connected at its ends with a respective pair of input clamps 2, 3. The processing unit 7 comprises three ADC converters 14, each comprising two electric terminals electrically connected with a respective pair of input clamps 2, 3 to detect the potential difference value at the respective pair of input clamps 2, 3, to thereby generate an output signal. The microcontroller 15 is in signal communication with the three ADC converters 14 and is configured to process the output signals to thereby generate at least one electric quantity measuring signal. The microcontroller 15 is in signal communication with each electronic switch 9, and is configured to control each electronic switch 9 to cause it to switch to the open configuration when the respective pair of input clamps 2, 3 receive the AC voltage V. Conversely, the microcontroller 15 is configured to control each electronic switch 9 to cause it to switch to the closed configuration when the respective pair of clamps 2, 3 receive the AC current I at their inputs. Preferably, in this preferred embodiment, the electric quantity transducers 6 are electric current sensors. More preferably, the type of electric quantity transducer is chosen according to the particular installation and may be selected in the microcontroller 15 via suitable software.

Concerning the electric quantity transducer 6 (e.g. a current sensor), its output terminals 4,5 are designed to be electrically connected to the two input clamps 2, 3.

Preferably, if the electric quantity measuring device 1 comprises multiple pairs of input clamps 2, 3, as is the case, for example, of a network analyzer of Fig. 3, then the same device comprises as many electric quantity transducers 6, each electrically connected with a respective pair of input clamps.

According to a preferred embodiment of the invention, the electric quantity measuring device 1 comprises a serial port, preferably a ModBus RS485 port, to provide the electric quantity measuring signal generated by the microcontroller 15 at its output. Preferably, the firmware of the microcontroller 15 also manages ModBus RS485 communication, allowing data exchange with external devices.

Advantageously, the present invention provides a device for measuring electric quantities that can receive both an AC current signal and an AC voltage signal at its input on the same pair of clamps.

Advantageously, the device for measuring electric quantities so obtained has a smaller size because both AC current and AC voltage measurements may be taken on the same pair of input clamps. Also, advantages may be derived from the possibility of installing the device for measuring electric quantities in a small container (e.g. 1 Din) with a smaller number of clamps.

Advantageously, the device for measuring electric quantities so obtained affords a reduction of manufacturing costs, due to the possibility of reducing the umber of electronic parts to be used. For instance, since the present invention allows both AC voltage and AC current measurements to be taken on the same pair of clamps, a single ADC converter may be used, instead of the two ADC converters required in the prior art. Furthermore, instead of using two devices to measure two electric quantities, i.e. one with an AC voltage input and the other with the AC current input, a single device may be used to alternately take AC current and AC voltage measurements.

Advantageously, the device for measuring electric quantities so obtained affords a reduction of power consumption, as it uses a smaller number of electronic parts to take as many measurements.

Advantageously, a network analyzer device may be provided, e.g. for analyzing three-phase networks, that can take alternating current measurements by receiving either an AC current signal or an AC voltage current at its input on the same pair of clamps.

Those skilled in the art will obviously appreciate that a number of changes and variants as described above may be made to fulfill particular requirements, without departure from the scope of the invention, as defined in the following claims.

## Claims

1. An electric quantity measuring device (1) comprising:
- two input clamps (2, 3) adapted to be electrically connected with two output terminals (4, 5) of an electric quantity transducer (6) for receiving an AC current (I) or an AC voltage (V) in said input terminals (2, 3),
- a processing unit (7) electrically connected with said two input clamps (2, 3) and configured to generate at least one electric quantity measuring signal for measuring electric quantities related to said AC current (I) and said AC voltage (V),
- a switch device (8) comprising one electronic switch (9) and resistive means (10) arranged in series, wherein one end of said electronic switch (9) is electrically connected with one of said two input terminals (2, 3) and one end of said resistive means (10) is electrically connected with the other of said two input clamps (2, 3), said electronic switch (9) being operably configured to switch between an open configuration in which it prevents the passage of electric current between said two input clamps (2, 3) and a closed configuration in which it allows the passage of electric current between said two input clamps (2, 3),
wherein
- said processing unit (7) detects a potential difference value at said two input clamps (2, 3) and, according to said potential difference value, said processing unit (7) is configured to cause said electronic switch (9) to switch to said open configuration when it detects that said two clamps (2, 3) receive said AC voltage (V) at their inputs, and to said closed configuration when it detects that said two clamps (2, 3) receive said AC current (I) at their inputs.
- said electronic switch (9) comprises two antiserially-connected N-type Mosfet transistors (11, 12) which are powered with a floating voltage, said processing unit (7) is configured to control said floating voltage between the gate and the source of said two Mosfet transistors (11, 12) to thereby switch said electronic switch (6) between said open configuration and said closed configuration,
**characterized in that**
- said electric quantity measuring device (9) comprises a charge pump (13) in signal communication with said processing unit (7), said processing unit (7) is configured to generate a PWM control signal with such a preset duty cycle frequency that the voltage Vgs between the gate and source electrodes of said two antiserially-connected Mosfet transistors (8, 9) will be at least 5V.

2. An electric quantity measuring device (1) as claimed in claim 1, wherein said processing unit (7) comprises:
- an ADC converter (14) comprising two electric terminals electrically connected with said two input clamps (2, 3) to receive said potential difference value at said two input clamps (2, 3) to thereby generate an output signal,
- a microcontroller (15) in signal communication with said ADC converter (14) and configured to process said output signal to thereby generate said at least one electric quantity measuring signal.

3. An electric quantity measuring device (1) as claimed in claim 2, wherein said microcontroller (15) is in signal communication with said electronic switch (9) and is configured to control said electronic switch (9) to cause it to switch to said open configuration when said two clamps (2, 3) receive said AC voltage (V) at their inputs and to cause it to switch to said closed configuration when said two clamps (2, 3) receive said AC current at their inputs.

4. An electric quantity measuring device (1) as claimed in claims 1 and 3, wherein said microcontroller (15) is configured to generate said PWM control signal at a preset frequency of about 100 kHz to control said charge pump (13) that will generate said floating voltage, so that the voltage between the gate and the source of said two Mosfet transistors (11, 12) will be at least 5V.

5. An electric quantity measuring device (1) as claimed in claim 3 or 4, wherein said microcontroller (15) is configured to cause said electronic switch (9) to switch to the open configuration when the value of said potential difference between one of said two clamps (2, 3) and the ground (GND) of said processing unit (7) said AC voltage (V) has a negative sign.

6. An electric quantity measuring device (1) as claimed in any of the preceding claims, wherein said electric quantity measuring device (1) is a three-phase network analyzer and comprises three pairs of input clamps (2, 3), each pair of clamps (2, 3) being adapted to be electrically connected with two respective output terminals (4, 5) of an electric quantity transducer (6) for receiving an AC current (I) or an AC voltage (V) at their inputs, said electric quantity measuring device (1) comprising three respective switch devices (8) each electrically connected at its ends with a respective pair of input clamps (2, 3),
- said processing unit (7) comprises three ADC converters (14), each comprising two electric terminals electrically connected to a respective pair of input clamps (2, 3) to receive said potential difference value at said pair of input clamps (2, 3) to thereby generate an output signal,
- said microcontroller (15) is in signal communication with said three ADC converters (14) and is configured to process said output signals to thereby generate said at last one electric quantity measuring signal, said microcontroller (15) being in signal communication with each electronic switch (9) and being configured to control each electronic switch (9) to cause it to switch to said open configuration when the respective pair of clamps (2, 3) receive said AC voltage (V) at their inputs and to cause it to switch to said closed configuration when the respective pair of clamps (2, 3) receive said AC current at their inputs.

## Patentansprüche

1. Elektrische Mengenmessvorrichtung (1), umfassend:
- zwei Eingangsklemmen (2, 3), die elektrisch mit zwei Ausgangsklemmen (4, 5) eines elektrischen Mengenumwerters (6) zum Empfangen eines Wechselstroms (I) oder einer Wechselspannung (V) in den Eingangsklemmen (2, 3) verbunden werden können,
- eine Verarbeitungseinheit (7), die elektrisch mit den beiden Eingangsklemmen (2, 3) verbunden und konfiguriert ist, um mindestens ein elektrisches Mengenmesssignal zum Messen elektrischer Größen in Bezug auf Wechselstrom (I) und Wechselspannung (V) zu erzeugen,
- eine Schaltvorrichtung (8), umfassend einen elektronischen Schalter (9) und in Reihe angeordnete Widerstandselemente (10), wobei ein Ende des elektronischen Schalters (9) elektrisch mit einem der beiden Eingangsanschlüsse (2, 3) verbunden ist und ein Ende der Widerstandselemente (10) elektrisch mit dem anderen der beiden Eingangsklemmen (2, 3) verbunden ist, der elektronische Schalter (9) funktionsfähig konfiguriert ist, um zwischen einer offenen Konfiguration, in der er den Durchgang von elektrischem Strom zwischen den beiden Eingangsklemmen (2, 3) verhindert und einer geschlossenen Konfiguration, in der er den Durchgang von elektrischem Strom zwischen den beiden Eingangsklemmen (2, 3) ermöglicht, umzuschalten, wobei
- die Verarbeitungseinheit (7) einen Potentialdifferenzwert an den beiden Eingangsklemmen (2, 3) erfasst und, gemäß dem Potentialdifferenzwert, die Verarbeitungseinheit (7) konfiguriert ist, um den elektronischen Schalter (9) zu veranlassen, in die offene Konfiguration umzuschalten, wenn sie erkennt, dass die beiden Klemmen (2, 3) Wechselspannung (V) an ihren Eingängen empfangen, und in die geschlossene Konfiguration umzuschalten, wenn sie erkennt, dass die beiden Klemmen (2, 3) Wechselstrom (I) an ihren Eingängen empfangen,
- der elektronische Schalter (9) zwei antiseriell verbundene N-Mosfet-Transistoren (11, 12) umfasst, die mit einer Erhaltungsspannung versorgt werden, wobei die Verarbeitungseinheit (7) konfiguriert ist, um die Erhaltungsspannung zwischen Gate und Source der beiden Mosfet-Transistoren (11, 12) zu steuern, um dadurch den elektronischen Schalter (6) zwischen der offenen Konfiguration und der geschlossenen Konfiguration umzuschalten, **dadurch gekennzeichnet, dass**
- die elektrische Mengenmessvorrichtung (9) eine Ladepumpe (13) in Signalverbindung mit der Verarbeitungseinheit (7) umfasst, wobei die Verarbeitungseinheit (7) konfiguriert ist, um ein PWM-Steuersignal mit einer solchen voreingestellten Tastfrequenz zu erzeugen, dass die Spannung Vgs zwischen Gate und Source-Elektroden der beiden antiseriell verbundenen Mosfet-Transistoren (8, 9) mindestens 5 V beträgt.

2. Elektrische Mengenmessvorrichtung (1) gemäß Anspruch 1, wobei die Verarbeitungseinheit (7) umfasst:
- einen ADC-Wandler (14) mit zwei elektrischen Anschlüssen, die elektrisch mit den beiden Eingangsklemmen (2, 3) verbunden sind, um den Potentialdifferenzwert an den beiden Eingangsklemmen (2, 3) zu empfangen und dadurch ein Ausgangssignal zu erzeugen,
- einen Mikrocontroller (15) in Signalverbindung mit dem ADC-Wandler (14) und konfiguriert, um das Ausgangssignal zu verarbeiten, um dadurch das mindestens ein elektrische Mengenmesssignal zu erzeugen.

3. Elektrische Mengenmessvorrichtung (1) gemäß Anspruch 2, wobei der Mikrocontroller (15) in Signalverbindung mit dem elektronischen Schalter (9) steht und konfiguriert ist, um den elektronischen Schalter (9) so zu steuern, dass er in die offene Konfiguration umschaltet, wenn die beiden Klemmen (2, 3) Wechselspannung (V) an ihren Eingängen empfangen, und um ihn zu veranlassen, in die geschlossene Konfiguration umzuschalten, wenn die beiden Klemmen (2, 3) Wechselstrom an ihren Eingängen empfangen.

4. Elektrische Mengenmessvorrichtung (1) gemäß den Ansprüchen 1 und 3, wobei der Mikrocontroller (15) konfiguriert ist, um das PWM-Steuersignal mit einer voreingestellten Frequenz von etwa 100 kHz zu erzeugen, um die Ladepumpe (13) zu steuern, die die Schwebespannung erzeugt, sodass die Spannung zwischen Gate und Source der beiden Mosfet-Transistoren (11, 12) mindestens 5 V beträgt.

5. Elektrische Mengenmessvorrichtung (1) gemäß den Ansprüchen 3 oder 4, wobei der Mikrocontroller (15) konfiguriert ist, um zu bewirken, dass der elektronische Schalter (9) in die offene Konfiguration umschaltet, wenn der Wert der Potentialdifferenz zwischen einer der beiden Klemmen (2, 3) und der Masse (GND) der Verarbeitungseinheit (7) die Wechselspannung (V) ein negatives Vorzeichen aufweist.

6. Elektrische Mengenmessvorrichtung (1), wie sie in einem der vorhergehenden Ansprüche beansprucht wird, wobei die elektrische Mengenmessvorrichtung (1) ein dreiphasiger Netzwerkanalysator ist und drei Paare von Eingangsklemmen (2, 3) umfasst, wobei jedes Paar von Klemmen (2, 3) geeignet ist, elektrisch mit zwei jeweiligen Ausgangsklemmen (4, 5) verbunden zu werden, eines elektrischen Mengenumwerters (6) zum Empfangen eines Wechselstroms (I) oder einer Wechselspannung (V) an ihren Eingängen, wobei die elektrische Mengenmessvorrichtung (1) drei jeweilige Schaltvorrichtungen (8) umfasst, die jeweils an ihren Enden mit einem entsprechenden Paar von Eingangsklemmen (2, 3) elektrisch verbunden sind,
- die Verarbeitungseinheit (7) drei ADC-Wandler (14) umfasst, die jeweils zwei elektrische Anschlüsse umfassen, die elektrisch mit einem entsprechenden Paar Eingangsklemmen (2, 3) verbunden sind, um den Potentialdifferenzwert an dem Paar Eingangsklemmen (2, 3) zu empfangen, um dadurch ein Ausgangssignal zu erzeugen,
- der Mikrocontroller (15) in Signalverbindung mit den drei ADC-Wandlern (14) steht und konfiguriert ist, um die Ausgangssignale zu verarbeiten, um dadurch das mindestens eine elektrische Mengenmesssignal zu erzeugen, wobei der Mikrocontroller (15) in Signalverbindung mit jedem elektronischen Schalter (9) steht und konfiguriert ist, um jeden elektronischen Schalter (9) zu steuern, um ihn dazu zu veranlassen, in die offene Konfiguration umzuschalten, wenn das jeweilige Paar von Klemmen (2, 3) Wechselspannung (V) an ihren Eingängen empfängt, und um ihn zu veranlassen, in die geschlossene Konfiguration umzuschalten, wenn das jeweilige Paar von Klemmen (2, 3) Wechselstrom an ihren Eingängen empfängt.

## Revendications

1. Dispositif de mesure de quantité électrique (1) comprenant :
- deux pinces d'entrée (2, 3) adaptées pour être connectées électriquement avec deux bornes de sortie (4, 5) d'un transducteur de quantité électrique (6) pour recevoir un courant CA (I) ou une tension CA (V) dans lesdites bornes d'entrée (2, 3),
- une unité de traitement (7) connectée électriquement avec lesdites deux pinces d'entrée (2, 3) et configurée pour générer au moins un signal de mesure de quantité électrique pour mesurer des quantités électriques relatives audit courant CA (I) et à ladite tension CA (V),
- un dispositif de commutation (8) comprenant un commutateur électronique (9) et des moyens résistifs (10) disposés en série, dans lequel une extrémité dudit commutateur électronique (9) est électriquement connecté à l'une desdites deux bornes d'entrée (2, 3) et une extrémité desdits moyens résistifs (10) est connectée électriquement à l'autre desdites deux pinces d'entrée (2, 3), ledit commutateur électronique (9) étant configuré de manière opérationnelle pour commuter entre une configuration ouverte dans laquelle il empêche le passage du courant électrique entre lesdites deux pinces d'entrée (2, 3) et une configuration fermée dans laquelle il permet le passage du courant électrique entre lesdites deux pinces d'entrée (2, 3),
dans lequel
- ladite unité de traitement (7) détecte une valeur de différence de potentiel aux dites deux pinces d'entrée (2, 3) et, en fonction de ladite valeur de différence de potentiel, ladite unité de traitement (7) est configurée pour amener ledit commutateur électronique (9) à commuter sur ladite configuration ouverte lorsqu'il détecte que lesdites deux pinces (2, 3) reçoivent ladite tension CA (V) au niveau de leurs entrées, et sur ladite configuration fermée lorsqu'il détecte que lesdites deux pinces (2, 3) reçoivent ledit courant CA (I) au niveau de leurs entrées.
- ledit commutateur électronique (9) comprend deux transistors Mosfet de type N (11, 12) à connexion antisérielle qui sont alimentés par une tension flottante, ladite unité de traitement (7) est configurée pour commander ladite tension flottante entre la grille et la source desdits deux transistors Mosfet (11, 12) pour commuter ainsi ledit commutateur électronique (6) entre ladite configuration ouverte et ladite configuration fermée,
**caractérisé en ce que**
- ledit dispositif de mesure de quantité électrique (9) comprend une pompe de charge (13) en communication de signal avec ladite unité de traitement (7), ladite unité de traitement (7) est configurée pour générer un signal de commande PWM avec une fréquence de rapport cyclique prédéfinie telle que la tension Vgs entre les électrodes de grille et de source desdits deux transistors Mosfet (8, 9) à connexion antisérielle sera d'au moins 5V.

2. Dispositif de mesure de quantité électrique (1) selon la revendication 1, dans lequel ladite unité de traitement (7) comprend :
- un convertisseur ADC (14) comprenant deux bornes électriques connectées électriquement aux dites deux pinces d'entrée (2, 3) pour recevoir ladite valeur de différence de potentiel au niveau des dites deux pinces d'entrée (2, 3) pour générer un signal de sortie,
- un microcontrôleur (15) en communication de signal avec ledit convertisseur ADC (14) et configuré pour traiter ledit signal de sortie afin de générer ainsi ledit au moins un signal de mesures de quantité électrique.

3. Dispositif de mesure de quantité électrique (1) selon la revendication 2, dans lequel ledit microcontrôleur (15) est en communication de signal avec ledit commutateur électronique (9) et est configuré pour commander ledit commutateur électronique (9) afin qu'il commute sur ladite configuration ouverte lorsque lesdites deux pinces (2, 3) reçoivent ladite tension CA (V) au niveau de leurs entrées et qu'il commute sur ladite configuration fermée lorsque lesdites deux pinces (2, 3) reçoivent ledit courant CA au niveau de leurs entrées.

4. Dispositif de mesure de quantité électrique (1) selon les revendications 1 et 3, dans lequel ledit microcontrôleur (15) est configuré pour générer ledit signal de commande PWM à une fréquence prédéfinie d'environ 100 kHz pour commander ladite pompe de charge (13) qui générera ladite tension flottante, de sorte que la tension entre la grille et la source desdits deux transistors Mosfet (11, 12) sera d'au moins 5V.

5. Dispositif de mesure de quantité électrique (1) selon la revendication 3 ou 4, dans lequel ledit microcontrôleur (15) est configuré pour amener ledit commutateur électronique (9) à commuter sur la configuration ouverte lorsque la valeur de ladite différence de potentiel entre l'une desdits deux pinces (2, 3) et la masse (GND) de ladite unité de traitement (7) ladite tension CA (V) a un signe négatif.

6. Dispositif de mesure de quantité électrique (1) selon l'une quelconque des revendications précédentes, dans lequel ledit dispositif de mesure de quantité électrique (1) est un analyseur de réseau triphasé et comprend trois paires de pinces d'entrée (2, 3), chaque paire de pinces (2, 3) étant adaptée pour être connectée électriquement à deux bornes de sortie (4, 5) respectives d'un transducteur de quantité électrique (6) pour recevoir un courant CA (I) ou une tension CA (V) au niveau de leurs entrées, ledit dispositif de mesure de quantité électrique (1) comprenant trois dispositifs de commutation (8) respectifs, chacun connecté électriquement à ses extrémités avec une paire respective de pinces d'entrée (2, 3),
- ladite unité de traitement (7) comprend trois convertisseurs ADC (14), chacun comprenant deux bornes électriques connectées électriquement à une paire respective de pinces d'entrée (2, 3) pour recevoir ladite valeur de différence de potentiel au niveau de ladite paire de pinces d'entrée (2, 3) afin de générer ainsi un signal de sortie,
- ledit microcontrôleur (15) est en communication de signal avec lesdits trois convertisseurs ADC (14) et est configuré pour traiter lesdits signaux de sortie afin de générer ainsi ledit au moins un signal de mesure de quantité électrique, ledit microcontrôleur (15) étant en communication de signal avec chaque commutateur électronique (9) et étant configuré pour commander chaque commutateur électronique (9) afin qu'il commute sur ladite configuration ouverte lorsque la paire respective de pinces (2, 3) reçoit ladite tension CA (V) au niveau de leurs entrées et pour le faire commuter sur ladite configuration fermée lorsque la paire respective de pinces (2, 3) reçoit ledit courant CA au niveau de leurs entrées.
